(19)

**Europäisches Patentamt**
**European Patent Office**
**Office européen des brevets**

(11) **EP 4 718 671 A1**

(12) **EUROPEAN PATENT APPLICATION**
published in accordance with Art. 153(4) EPC

(43) Date of publication:
01.04.2026 Bulletin 2026/14

(21) Application number: 24832341.2

(22) Date of filing: 17.06.2024

(51) International Patent Classification (IPC):
$H02J\ 7/04^{(2006.01)}$     $H02J\ 7/00^{(2026.01)}$
$G01R\ 31/382^{(2019.01)}$

(52) Cooperative Patent Classification (CPC):
G01R 31/382; H02J 7/00; H02J 7/04

(86) International application number:
PCT/KR2024/008280

(87) International publication number:
WO 2025/005561 (02.01.2025 Gazette 2025/01)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 26.06.2023 KR 20230081882
14.09.2023 KR 20230122515

(71) Applicant: **Samsung Electronics Co., Ltd.
Suwon-si, Gyeonggi-do 16677 (KR)**

(72) Inventors:
• **RYU, Sanghyun
Suwon-si, Gyeonggi-do 16677 (KR)**
• **NOH, Seungduck
Suwon-si, Gyeonggi-do 16677 (KR)**
• **OH, Hyunjun
Suwon-si, Gyeonggi-do 16677 (KR)**
• **LEE, Jeongho
Suwon-si, Gyeonggi-do 16677 (KR)**

(74) Representative: **HGF
HGF Limited
4th Floor, 1 City Square
Leeds LS1 2ES (GB)**

(54) **ELECTRONIC DEVICE AND CHARGING METHOD USING SAME**

(57) This electronic device may comprise: a first charger including any one of a battery buck converter, a boost converter, or an LDO regulator; a second charger including a power converter that increases an input current, supplied from an external device, by a designated factor, and outputs the increased current, and decreases an input voltage, supplied from the external device, by the designated factor and outputs the decreased voltage; and a processor. The processor can: identify whether the external device can adjust the output voltage and/or the output current on the basis that the external device is connected; supply a charging current by using the second charger on the basis that the external device is in a state in which the setting of the output voltage and/or the output current is fixed; and supply the charging current to the battery by additionally using the first charger on the basis that the charging current being supplied by the second charger of the electronic device has fallen below the maximum outputtable current value of the external device.

FIG. 5

500

START

IDENTIFY WHETHER EXTERNAL ELECTRONIC DEVICE IS ABLE TO ADJUST OUTPUT VOLTAGE AND/OR OUTPUT CURRENT, BASED ON THAT EXTERNAL ELECTRONIC DEVICE IS CONNECTED — 510

PERFORM CHARGING USING SECOND CHARGER, BASED ON THAT CONFIGURATIONS OF OUTPUT VOLTAGE AND/OR OUTPUT CURRENT ARE FIXED — 520

PERFORM CHARGING BY ADDITIONALLY USING FIRST CHARGER, BASED ON THAT CHARGING CURRENT USING SECOND CHARGER BECOMES LOWER THAN PREDETERMINED CONFIGURATION VALUE — 530

END

## Description

[Technical Field]

The disclosure relates to an electronic device and, for example, to an electronic device and a charging method using the same.

[Background Art]

An electronic device may include a battery to supply power necessary to perform various functions. The electronic device may receive power from a power transmission device wiredly or wirelessly and charge the battery.

A power reception device may perform data communication with a power supply device (for example, a travel adapter (TA)) using a specified protocol (for example, power data objects (PDO) or a programmable power supply (PPS)) for power delivery (PD) communication, and receive power from the power supply device.

A charger (for example, a travel adapter) may be connected to the electronic device wiredly and configured to supply power to the electronic device. The electronic device (for example, a smartphone) may charge the battery by using the power supplied from the charger, and supply the power to a load circuit (for example, a processor) to operate the load circuit. For example, the supply power supplied from the charger to the electronic device may be distributed to the battery and the load circuit through a power management circuit.

The charger supporting programmable power supply (PPS) communication may provide the electronic device with an enhanced charging function. The PPS may refer to a communication protocol that allows the charger and a device (for example, a UE) being charged to dynamically adjust power-related parameters (for example, current, voltage) during a charging process. The charger supporting the PPS may communicate with a connected device to determine an optimal charging voltage and current level, based on specific requirements and functions.

[Disclosure of Invention]

[Technical Problem]

A PD charger that does not support PPS may have a limit in performing charging up to 15W by using a PMIC.

When a direct charger is used for a high-power PD charger that does not support PPS, it is possible to perform charging with 15W or more, but there is a limitation in that as the battery voltage increases, the charging current decreases, and therefore, charging must be done with a smaller current compared to the case in which a charger supporting PPS is used.

The electronic device and the charging method using the same according to the disclosure are intended to prevent a phenomenon in which a charging current is reduced by simultaneously using a direct charger and a PMIC, even when the charger does not support PPS.

An electronic device may include a battery, a first charger including one of a buck converter, a boost converter, or an LDO regulator, a second charger including a power converter configured to increase an input current supplied from an external device by a predetermined factor and output the increased current, and decrease an input voltage supplied from the external device by the predetermined factor and output the decreased voltage, and a processor. The processor may be configured to identify whether the external device is able to adjust the output voltage and/or the output current based on that the external device is connected, supply a charging current by using the second charger based on the external device being in a state where the output voltage and/or the output current are fixed, and supply a charging current to the battery by additionally using the first charger based on the charging current of the electronic device, using the second charger, becoming lower than a maximum outputtable current value of the external device.

A method of operating an electronic device may include identifying whether an external device is able to adjust an output voltage and/or an output current based on the external device being connected, supplying a charging current by using a second charger based on the external device being in a state where the output voltage and/or the output current are fixed, and supplying a charging current to a battery by additionally using a first charger based on the charging current of the electronic device, using the second charger, becoming lower than a maximum outputtable current value of the external device.

The electronic device and the charging method using the same according to the disclosure may improve a charging speed and maintain a high charging efficiency by simultaneously using a direct charger and a PMIC for a charger that does not support PPS.

The electronic device and the charging method using the same according to the disclosure may improve the charging speed using the PMIC while limiting the PMIC charging current to minimize heating generated in a battery circuit during charging.

[Brief Description of Drawings]

FIG. 1 is a block diagram of an electronic device in a network environment according to various embodiments.
FIG. 2 is a block diagram of a power management module and a battery according to an embodiment.
FIG. 3A is a circuit diagram illustrating a process of charging the battery according to a comparative embodiment.
FIG. 3B is a graph illustrating a battery charging current for each time according to whether a programmable power supply (PPS) is supported.
FIG. 4 is a block diagram of a configuration of an electronic device according to an embodiment.
FIG. 5 is a sequence diagram illustrating a method of charging the electronic device according to an embodiment.
FIG. 6 is a flowchart illustrating the method of charging the electronic device according to an embodiment.

[Mode for the Invention]

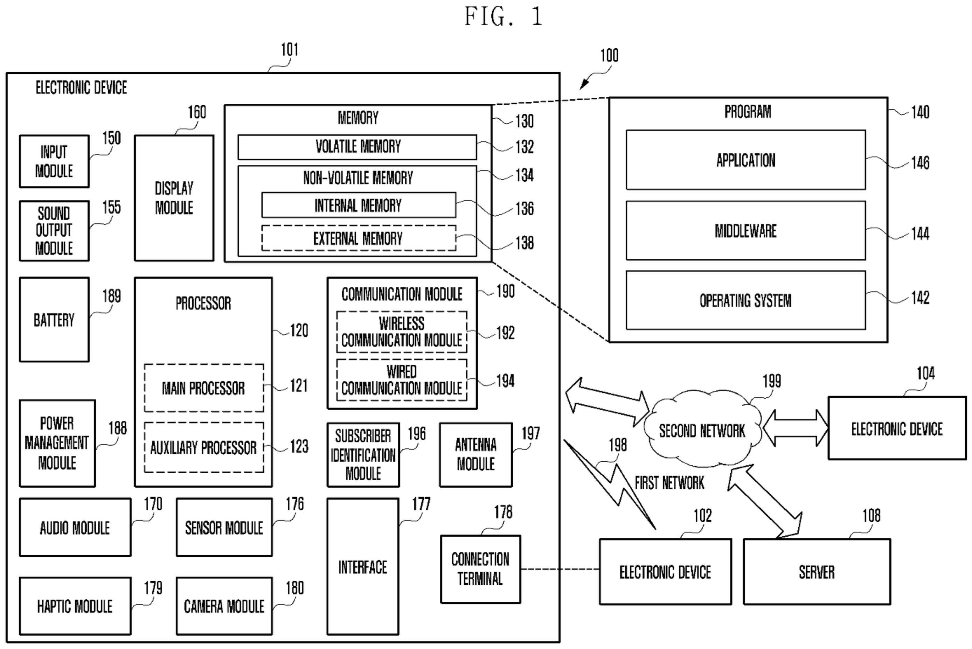

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

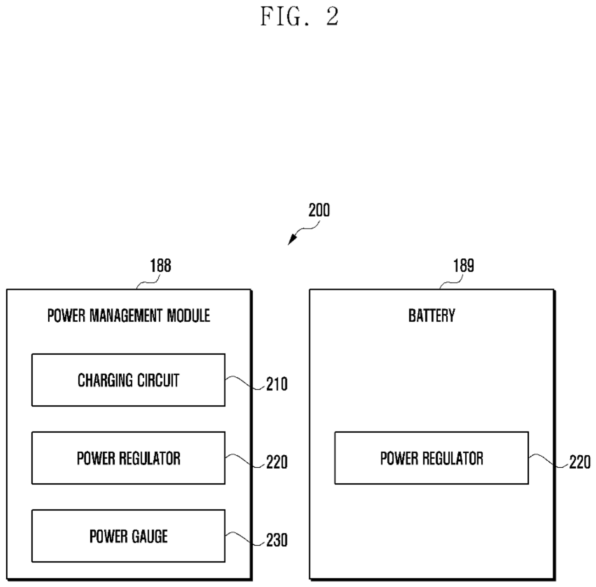

FIG. 2 is a block diagram 200 of the power management module 188 and the battery 189 according to an embodiment. Referring to FIG. 2, the power management module 188 may include a charging circuit 210, a power regulator 220, or a power gauge 230. The charging circuit 210 may charge the battery 189 with power supplied from an external power source of the electronic device 101. According to an embodiment, the charging circuit 210 may select a charging method (for example, normal charging or fast charging), based on at least one of a type of the external power source (for example, a power adapter, USB, or wireless charging), a power magnitude (for example, about 20 watts or more) that can be supplied from the external power source, or attributes of the battery 189, and may charge the battery 189 by using the selected charging method. The external power source may be wiredly connected through, for example, the connectivity terminal 178 or wirelessly connected through the antenna module 197.

The power regulator 220 may generate a plurality of powers having different voltage or current levels by controlling a voltage level or a current level of power supplied from, for example, the external power source or the battery 189. The power regulator 220 may control power of the external power source or the battery 189 to be a voltage or current level suitable for some or each of the elements included in the electronic device 101. According to an embodiment, the power regulator 220 may be implemented in the form of a low drop out (LDO) regulator or a switching regulator. The power gauge 230 may measure usage state information (for example, a capacity of the battery 189, the number of charges/-discharges, a voltage, or a temperature) of the battery 189.

The power management module 188 may determine charging state information (for example, lifespan, overvoltage, undervoltage, overcurrent, overcharging, overdischarging, overheating, short circuit, or swelling) related to charging of the battery 189 on the basis of at least some of the measured usage state information through, for example, the charging circuit 210, the voltage regulator 220, or the power gauge 230. The power management module 188 may determine whether the battery 189 is normal or malfunctioning on the basis of at least some of the determined charging state information. When it is determined that the state of the battery 189 is abnormal, the power management module 188 may control charging of the battery 189 (for example, reduce the charging current or voltage or stop charging). According to an embodiment, at least some of the functions of the power management module 188 may be performed by an external control device (for example, the processor 120).

The battery 189 may include a battery protection circuit module (PCM) 240 according to an embodiment. The battery protection circuit 240 may perform one or more of various functions (for example, a pre-blocking function) to prevent performance deterioration or damage of the battery 189. The battery protection circuit 240 may be additionally or alternatively configured as at least part of a Battery Management System (BMS) for performing cell balancing, battery capability measurement, measurement of the number of charges/discharges, temperature measurement, or voltage measurement.

According to an embodiment, at least a portion of the usage state information or the charging state information of the battery 189 may be measured using a corresponding sensor (for example, a temperature sensor) in the sensor module 276, the power gauge 230, or the power management module 188. According to an embodiment, the corresponding sensor (for example, the temperature sensor) in the sensor module 176 may be included as a part of the battery protection circuit 140, or may be disposed near the battery 189 as a device separate therefrom.

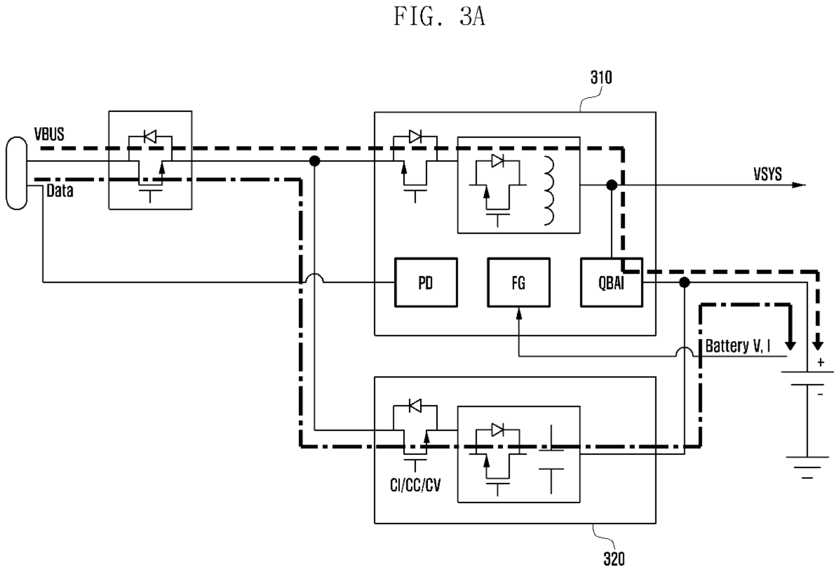

FIG. 3A is a circuit diagram illustrating a charging process of the battery according to a comparative embodiment.

According to FIG. 3A, the charging circuit diagram of the battery may include a first charger 310 and a second charger 320 (for example, a direct charging circuit). An electronic device according to the comparative embodiment may perform charging of the battery by using the first charger 310 in normal charging and fast charging. The electronic device according to the comparative embodiment may perform charging of the battery by using the second charger 320 during super-fast charging.

A charger supporting programmable power supply (PPS) communication may provide the electronic device with an enhanced charging function. The PPS may refer to a communication protocol that allows the charger and a device (for example, a UE) being charged to dynamically adjust power-related parameters (for example, current, voltage) during a charging process. The charger supporting the PPS may communicate with the connected device to determine the optimal charging voltage and current level, based on specific requirements and functions.

When the electronic device is charged via the first charger 310 for a charger that does not support the PPS, a 90% level of efficiency may be obtained during high-power charging, so that a heat generation phenomenon may occur, or a charging speed may be slowed. There is a problem in that the surface temperature of the electronic device increases, and thus the battery may be charged with only the current at a maximum level of 3A.

The electronic device may be charged via the second charger (for example, the direct charging circuit) 320 for the charger that does not support the PPS.

When the second charger 320 is used for the charger that does not support the PPS, the charging current may be reduced as the battery voltage increases, and thus the charging current may be relatively reduced and the charging speed may be slowed down, as compared to a charger that supports the PPS.

The electronic device according to the disclosure may perform charging with the maximum current that can be output from the charger by simultaneously using the first charger 310 and the second charger 320, in a situation where the charger that does not support the PPS is connected.

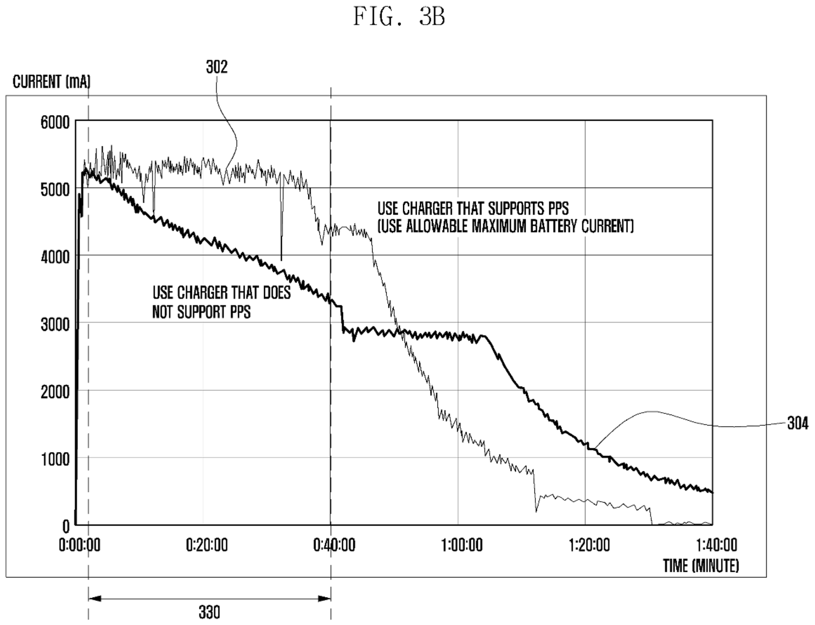

FIG. 3B is a graph illustrating a battery charging current for each time according to the presence or absence of a programmable power supply (PPS).

The horizontal axis of the graph in FIG. 3B may indicate time, and the vertical axis may indicate a charging current. A first graph 302 illustrates a charging current for each time when charging is performed using the charger that supports the PPS. A second graph 304 illustrates a charging current for each time when the charging is performed using the charger that cannot support the PPS.

In a situation where the charger that supports the PPS is used, the electronic device may perform charging with a maximum current allowed by the battery. On the other hand, in a situation where the charger that is unable to support the PPS is used, the charging current may decrease as the charging voltage of the battery increases when the second charger 320 is used. It may be identified that the y-axis value of the second graph 304 decreases gradually as time passes in an initial charging period 330. It may be identified that the y-axis value of a first graph 302 is maintained at a relatively constant value even as time passes in the initial charging section 330. It may be seen that the charging is performed with a higher current in the first graph 302 than the second graph 304.

It may be identified that the charging speed in the first graph 302 is faster than that in the second graph 304, due to the difference in the charging current values in the first graph 302 and the second graph 304 in the initial charging stage 330. It may be identified that, while in the first graph 302 using the charger that can support the PPS, a relatively large amount of charging is performed in the initial section 330 and thus the charging current sharply decreases thereafter, in the second graph 304, an amount of charging is insufficient in the initial section 330 and thus the charging current is maintained for a relatively long time thereafter.

The electronic device according to the disclosure may perform charging with the maximum current that can be output from the charger by simultaneously using the first charger 310 and the second charger 320, in a situation where the charger that does not support the PPS is connected. The electronic device according to the disclosure may provide a relatively faster charging speed even in a situation where the charger that does not support the PPS is connected.

According to various embodiments, in other charging sections (not illustrated) as well as the initial charging section 330, when the charger that is not able to support the PPS is used, the charging current may be low and thus the charging speed may be low compared to the case in which the charger is able to support the PPS. According to various embodiments, the battery 410 may be charged by using the charger that is not able to support the PPS in other charging sections (not illustrated) as well as the charging initial section 330. Depending on a voltage state of the battery 410, the charging voltage and/or current setting of the charger that is not able to support the PPS may be changed.

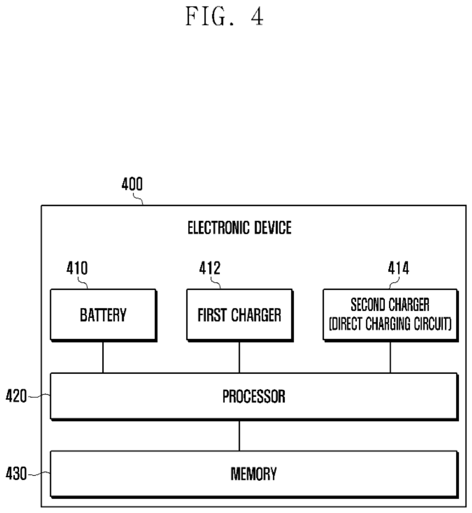

FIG. 4 is a block diagram of a configuration of an electronic device according to an embodiment.

According to an embodiment, an electronic device 400 may include a battery 410, a first charger 412, a second charger 414, a processor 420, and a memory 430, and some of the illustrated configurations may be omitted or replaced. The electronic device may further include at least some of the configurations and/or functions of the electronic device 101 of FIG. 1. At least some of the configurations of the electronic device which are (or are not) illustrated may be operatively, functionally, and/or electrically connected to each other. According to an embodiment, the processor 420 may be a component which may perform operations or data processing related to control and/or communication of the respective configurations of the electronic device, and may include one or more processors. According to an embodiment, the processor may include at least a part of the configurations and/or functions of the processor 120 of FIG. 1. According to an embodiment, the processor 420 may include a configuration for controlling a separate charger of a power management module (for example, the power management module 188 of FIG. 1).

According to an embodiment, there is no limitation in calculations and data processing functions that can be implemented in the electronic device by the processor 420, but features related to the control of the battery 410 and a power management integrated circuit (PMIC) will be described in detail in the following description. The operations of the processor 420 may be performed by loading instructions stored in the memory 430.

According to an embodiment, the electronic device 400 may include one or more memories 430, and the memory 430 may include a main memory and a storage. The main memory may be configured as a volatile memory such as a dynamic random access memory (DRAM), a static RAM (SRAM), or a synchronous dynamic RAM (SDRAM). Alternatively, the memory 430 may include a storage device of a large capacity as a non-volatile memory. The storage may include at least one of a one-time programmable ROM (OTPROM), a PROM, an EPROM, an EEPROM, a mask ROM, a flash ROM, a flash memory, a hard disk, or a solid state drive (SSD). The memory 430 may store various file data, and the stored file data may be updated according to the operation of the processor 420.

According to an embodiment, the battery 410 may supply power to at least one component of the electronic device 400. According to an embodiment, the battery 410 may include, for example, a rechargeable secondary battery.

A power management integrated circuit (PMIC) may refer to an integrated circuit (for example, the power management module 188 in FIG. 1) which is responsible for managing and supplying power efficiently in an electronic device 400.

The PMIC may adjust power by converting a voltage level through a DC-DC converter to provide various power levels. For example, the PMIC may convert the input power to a low voltage required by the battery and convert the input power to a voltage suitable for the core components of the system. The PMIC may include a first charger 412 and a second charger 414. For example, the first charger 412 may be a charging circuit including at least one of a buck converter, a boost converter, and a low dropout (LDO) regulator. The second charger 414 may be a charging circuit that changes the input voltage at an N:1 ratio and outputs the same. For example, the second charger 414 may be a direct charging circuit or a switched capacitor voltage divider circuit. The second charger 414 may refer to a direct charging circuit that provides a constant voltage and current to charge the battery.

According to an embodiment, the processor 420 may identify whether the external device is a charger capable of adjusting an output voltage and an output current based on the external device being connected, supply a charging voltage by using the second charger (for example, a direct charger 414) based on the external device being a charger having a fixed output voltage and a fixed output current, identify the output current of the battery, and supply a charging voltage by additionally using the first charger 412 based on the output current of the battery being lower than a predetermined configuration value.

The first power supply 412 may include, for example, at least one of a buck converter, a boost converter, and an LDO regulator.

The first charger 412 may adjust power by converting a voltage level through a DC-DC converter to provide various power levels. For example, the first charger 412 may convert input power into a low voltage required for the battery to convert the input power into a voltage suitable for components of the system.

The first charger 412 may control battery charging. It is possible to efficiently charge the battery or prevent overcharging or overdischarging, so as to extend the battery life and maintain the stable operation.

The second charger 414 may include a power converter configured to increase the input current supplied from the external device by a predetermined ratio and output the same, and to reduce the input voltage supplied from the external device by a predetermined ratio and output the same. The second charger 414 may refer to, for example, a direct charger.

The processor 420 may determine the current output from the charger, based on the current charging voltage of the battery and the resistance value of the charging circuit. The processor 420 may calculate a current that the charger can additionally supply, based on the current value output from the charger and the maximum current value which can be output from the charger.

According to an embodiment, an output current of the external device (for example, a charger) may be determined by the following equation.

output current of charger = ( voltage of charger -2* voltage of battery)/ (resistance between charger and battery)  [Equation 1]

It may be identified that the output current of the charger in [Equation 1] is proportional to the voltage of the charger and inversely proportional to the voltage of the battery 410. As the voltage of the battery 410 increases during the charging, the output current of the charger may decrease. A situation where the output current of the charger decreases and thus the charging is delayed has been described with reference to the second graph 304 in FIG. 3B above. The graph of FIG. 3B is only an example, and the charging current of the first charger 310 and the second charger 320 according to time may vary according to a configuration.

In a situation where the charger not supporting the PPS is connected, the electronic device 400 according to the disclosure may perform charging with the maximum current that can be output from the charger by simultaneously using the first charger 412 and the second charger 414. Even in a situation where a charger not supporting the PPS is connected, the electronic device 400 according to the disclosure may compensate for the charging current by using the first charger 412 and provide a relatively faster charging rate.

According to an embodiment, [Table 1] and [Table 2] below are merely examples in the case that the charger is configured as a maximum current of 3A when the battery voltage is 4.14V or more, and the disclosure is not limited thereto. Depending on a type, a capacity, and a state of the battery, a state of the battery voltage may be different, and the charger supply power configuration according thereto may be different. [Table 1] below shows a value obtained by calculating the additional current that can be supplied from the charger, based on the battery voltage and the current value which can be output from the charger for each battery voltage. For example, the mode in which the voltage of power supplied by the charger not supporting the PPS is 9V and the current is 3A may be used. The maximum current that can be supplied from the charger may be 3A. The current output from the charger for each battery voltage may correspond to a charging current using the second charger 414. The current that can be additionally supplied from the charger may correspond to a charging current which can be additionally supplied through the first charger 412.

The charging current using the second charger 414 and the charging current that can be additionally supplied through the first charger 412 as shown in [Table 1] is only an example, and is not limited thereto. The charging current using the second charger 414 and the charging current that can be additionally supplied through the first charger 412 may vary depending on the battery voltage.

[Table 1]

| Battery voltage (V) | Current (A) output from second charger (direct charging circuit) for each battery voltage | Current (A) that can be additionally supplied by first charger |
| --- | --- | --- |
| 4.14 | 3 | 0 |
| 4.2 | 2.5 | 0.5 |
| 4.25 | 2.08 | 0.92 |

(continued)

| Battery voltage (V) | Current (A) output from second charger (direct charging circuit) for each battery voltage | Current (A) that can be additionally supplied by first charger |
|---|---|---|
| 4.3 | 1.67 | 1.33 |
| 4.35 | 1.25 | 1.75 |
| 4.47 | 0.5 | 2.5 |

Since a current higher than the output current acceptable to the charger may be output in a situation where the battery voltage is, for example, less than 4.14V, the processor 420 may control the second charger (for example, a direct charging circuit (direct charger) 414 so as to maintain the output current of the charger as a predetermined value (for example, 3A) or smaller.

However, in a situation where the battery voltage exceeds 4.14V, the difference between the maximum output voltage of the charger and the battery voltage may be reduced. When the difference between the maximum output voltage of the charger and the battery voltage is reduced, the output current of the charger may also be reduced. For example, in a situation where the battery voltage is 4.25V, the output current of the charger may be 2.5A. The processor 420 may determine that the current of 0.5A may be additionally supplied in a situation where the maximum output current acceptable to the charger is 3A.

According to the disclosure, the processor 420 may additionally supply a current (for example, 0.5A) that may be additionally supplied using the first charger 412 to the battery 410. The processor 420 may supply the current and voltage to the battery 410 by simultaneously using the direct charging circuit (direct charger) 414 and the first charger 412.

According to an embodiment, the processor 420 may limit an amount of the current additionally supplied to the battery 410 by using the first charger 412. When the amount of current supplied from the first charger 412 exceeds a predetermined level, the electronic device 400 may have difficulty in controlling heating of the surface of the electronic device 400, and thus the processor 420 may limit the amount of current supplied using the first charger 412.

[Table 2] below shows the final output current of the charger in a situation where the processor 420 limits the amount of current supplied using the first charger 412 to 1.65A.

[Table 2]

| Battery voltage (V) | Current (A) output from second charger for each battery voltage | Current (A) that can be additionally supplied by first charger | Charging current (A) of first charger | Final TA output current (A) |
|---|---|---|---|---|
| 4.14 | 3 | 0 | 0 | 3 |
| 4.2 | 2.5 | 0.5 | 0.5 | 3 |
| 4.25 | 2.08 | 0.92 | 0.92 | 3 |
| 4.3 | 1.67 | 1.33 | 1.33 | 3 |
| 4.35 | 1.25 | 1.75 | 1.65 | 2.9 |
| 4.47 | 0.5 | 2.5 | 1.65 | 2.15 |

According to an embodiment, the processor 420 may reduce the amount of supplied current as the charging becomes closer to a completion state. The processor 420 may reduce the current supplied by the PMIC as the charging becomes closer to a completion state.

The processor 420 may determine the amount of current supplied using the first charger 412 as a preconfigured value (for example, 1.65A). The amount of current supplied using the first charger 412 may vary depending on a configuration.

For example, in a situation where the voltage of the battery 410 is 4.35V and the current that can be output from the charger is 1.25A, the processor 420 may receive a current (for example, 1.65A) corresponding to a previously configured value by using the first charger 412. The processor 420 may control heating of the surface of the electronic device 400 by limiting the current supplied to the battery 410 by using the first charger 412.

According to an embodiment, the processor 420 may determine the current output current of the battery 410, based on the voltage of the battery 410 and the resistance value on the charging circuit, determine a current value which can be additionally supplied based on the current output current value of the battery and the maximum output current value of the battery 410, and determine a current value to be additionally supplied through the first charger (for example, the first charger 412), based on the current value which can be additionally supplied. The first charger may include, for example, the first charger 412.

According to an embodiment, the processor 420 may determine a value obtained by subtracting the current output current value of the battery 410 from the maximum output current value of the battery 410 as the current value which can be additionally supplied, and determine a current value to be additionally supplied through the first charger, based on the current value which can be additionally supplied.

According to an embodiment, the processor 420 may preconfigure an upper limit of the current value to be additionally supplied through the first charger, and control the current value additionally supplied through the first charger to not exceed the configured value.

According to an embodiment, the processor 420 may receive a list of a power data objects (PDOs) including information on the voltage and current that may be supplied to the battery 410 from the external device.

According to an embodiment, the processor 420 may select a PDO from the list to determine the voltage and current to be supplied to the battery 410.

According to an embodiment, the processor 420 may, based on the voltage and current to be supplied to the battery 410 being determined, first supply the voltage and current by using the second charger (for example, the direct charging circuit 414), determine the current output current value of the battery 410 based on the voltage of the battery 410, and determine to additionally supply the current through the first charger based on the maximum output current value of the battery 410 exceeding the current output current value of the battery 410. The second charger 414 may include, for example, the direct charging circuit 414.

According to an embodiment, the processor 420 may supply a charging voltage and current to the battery by using the first charger 412, based on the charging power of the external device being lower than a first level. The first level may include, for example, 15W. When the charging power of the external device is lower than the first level, the processor 420 may classify a charging state as normal charging or fast charging.

According to an embodiment, the processor 420 may identify whether the external device is a charger capable of adjusting an output voltage and an output current based on the charging power of the external device exceeding a second level, and supply a charging voltage and current to the battery 410 by using the second charger or supply a charging voltage and current to the battery 410 by using the first charger and the second charger simultaneously based on a type of the external device. The second level may include, for example, 25W. When the charging power of the external device exceeds the second level, the processor 420 may classify the charging state as super-fast charging.

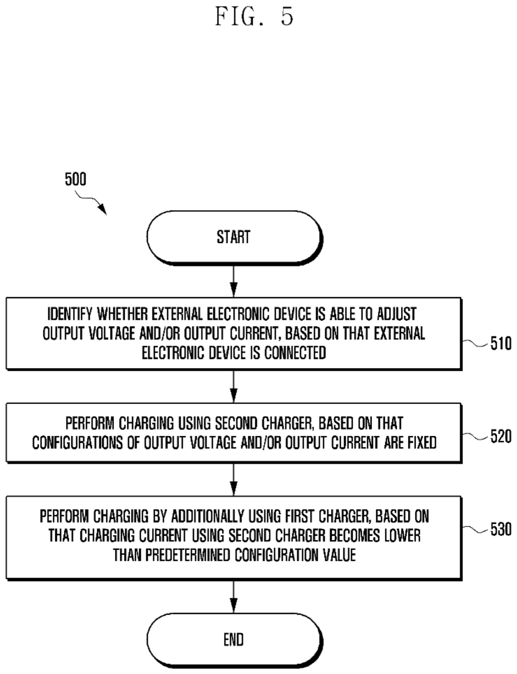

FIG. 5 is a flowchart illustrating a charging method of an electronic device according to an embodiment.

The operations described with reference to FIG. 5 may be implemented based on instructions that may be stored in a computer recording medium or a memory (for example, the memory 130 of FIG. 1). The illustrated method 500 may be performed by the electronic device (for example, the electronic device 400 of FIG. 4) described with reference to FIGs. 1 to 4, and the technical features described above will be omitted below. The order of respective operations in FIG. 5 may be changed, some operations may be omitted, and some operations may be simultaneously performed.

In operation 510 of FIG. 5, a processor (for example, the processor 420 of FIG. 4) may identify whether the external device is able to adjust the output voltage and/or the output current, based on the external device being connected. A charger capable of adjusting the output voltage and the output current may include, for example, a charger that can support PPS communication. The charger that supports the programmable power supply (PPS) communication may provide the electronic device with an enhanced charging function. The PPS may refer to a communication protocol that allows the charger and a device (for example, a UE) being charged to dynamically adjust power-related parameters (for example, current or voltage) during a charging process. The charger supporting the PPS may communicate with the connected device to determine the optimal charging voltage and current level, based on specific requirements and functions.

In operation 520 of FIG. 5, the processor 420 may proceed with charging by using a second charger (for example the second charger 414 of FIG. 4), based on the connected external device having performed charging with a fixed voltage for a predetermined period. The second charger 414 may include a power converter configured to increase the input current supplied from the external device by a predetermined ratio and output the same, and to reduce the input voltage supplied from the external device by a predetermined ratio and output the same. The second charger 414 may refer to, for example, a direct charging circuit (direct charger) (for example, the second charger (direct charging circuit) 414 of FIG. 4).

The direct charging circuit 414 may include a circuit (for example, a capacitor voltage divider circuit) configured to convert a voltage value of a power signal received from a power supply device through an overvoltage protection circuit at a fixed voltage conversion ratio but to charge a battery (for example, the battery 410 of FIG. 4) at a high speed without power loss (or while minimizing power loss). When the loss rate of power in the direct charging circuit 414 is ideally "0", the ratio of the output power output from the output terminal of the direct charging circuit 414 to the input power input into the input terminal of the direct charging circuit 414 may be "1". For example, the direct charging circuit 414 may include an N:1 direct charging integrated circuit (DCIC) configured to distribute the input voltage input into the input terminal using a plurality of capacitors (for example, N capacitors) to lower the input voltage by 1/N times (where N is 2 or a natural number larger than 2) and output the same through the output terminal, and to increase an input current input into the input terminal by N times using the plurality of capacitors and output the same through the output terminal.

In operation 530 of FIG. 5, the processor 420 may proceed with the charging by additionally using the first charger, based on that the charging current using the second charger 414 becomes lower than a predetermined configuration value. The first charger 412 may refer to, for example, a PMIC or a buck charger.

The PMIC may adjust power by converting a voltage level through a DC-DC converter to provide various power levels. For example, the PMIC may convert input power to a voltage suitable for a core component of the system by converting the input power to a low voltage required for the battery.

The PMIC may include a first charger 412 and a second charger 414. For example, the first charger 412 may be at least one charging circuit among a buck converter, a boost converter, and a low dropout (LDO) regulator. The second charger 414 may be a charging circuit that changes the input voltage at an N:1 ratio and outputs the same. For example, the second charger 414 may be a switched capacitor voltage divider circuit.

Based on the output current of the battery 410 becoming lower than the predetermined configuration value, the processor 420 may supply the charging voltage by using the first charger 412 together with the second charger 414.

The processor 420 may supply a charging voltage and current to the battery 410 by using the first charger 412, based on the charging power of the external device being lower than a first level (for example, 15W). The processor 420 may identify, based on the charging power of the external device exceeding a second level (for example, 25W), whether the external device is a charger capable of adjusting the output voltage and the output current, and perform control to supply the charging voltage and current to the battery 410 by using the second charger 414 or using the first charger 412 and the second charger 414 simultaneously, based on the type of the external device. Here, the first level may refer to charging power lower than the second level. When the charging power of the external device is lower than the first level, it may correspond to either one of the normal charging or fast charging. The fast charging may refer to a scheme in which the battery 410 is charged at a relatively faster rate than general charging.

When charging power of the external device exceeds the second level, it may indicate a super-fast charging scheme. The super-fast charging scheme may be a scheme of charging the battery at a rate relatively faster than the fast charging.

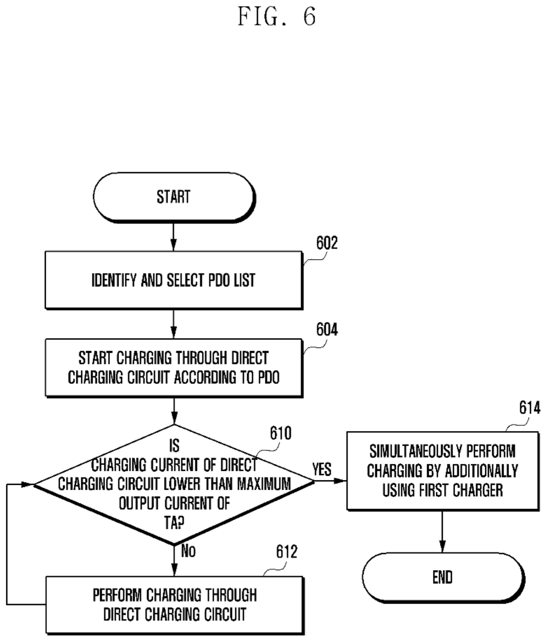

FIG. 6 is a flowchart illustrating a charging method of an electronic device according to an embodiment.

Operations described through FIG. 6 may be implemented based on instructions which can be stored in a computer recording medium or a memory (for example, the memory 130 of FIG. 1). The illustrated method 600 may be performed by the electronic device (for example, the electronic device 400 of FIG. 4) described with reference to FIGs. 1 to 4, and the technical features described above will be omitted below. The order of respective operations in FIG. 6 may be changed, some operations may be omitted, and some operations may be simultaneously performed.

In operation 602 of FIG. 6, a processor (for example, the processor 420 of FIG. 4) may receive a list of power data objects (PDOs) including information on the voltage and current that may be supplied from a charger (for example, a travel adapter (TA)) to a battery (for example, the battery 410 of FIG. 4), and select an appropriate PDO from the list to determine the voltage and current to be supplied. USB PD may be a standardized protocol that allows for fast charging and power supply through a USB connection. In USB PD, a power data object (PDO) may indicate a specification of specific power that may be provided by a USB PD power supply (for example, a charger or a power adapter). The PDO may include information on a voltage and current level that may be delivered to a device to which the power supply is connected. Each USB PD power supply may include a plurality of PDOs indicating various power supply profiles that may be supported. The PDO list may include information on voltages and currents of a plurality of PDOs.

According to an embodiment, the processor 420 may receive a list of a power data objects (PDOs) including information on the voltage and current that may be supplied to the battery 410 from the external device. The processor 420 may select a PDO from the received list to determine the voltage and current to be supplied to the battery 410.

In operation 604 of FIG. 6, the processor 420 may start charging by using a direct charging circuit (for example, the direct charging circuit 414 of FIG. 4), based on a voltage level and a current level to be supplied being determined based on the PDO list. The direct charging circuit 414 may include a circuit (for example, a capacitor voltage divider circuit) configured to convert a voltage value of a power signal received from a power supply device through an overvoltage protection circuit at a fixed voltage conversion ratio but to charge a battery (for example, the battery 410 of FIG. 4) at a high speed without power loss (or while minimizing power loss).

According to an embodiment, the processor 420 may determine based on the voltage and current to be supplied to the battery, to preferentially supply the voltage and the current by using the second charger 414, determine a current output current value of the battery 410 based on the voltage on the battery 410, and determine to additionally supply a current through the first charger 412 based on the maximum output current value of the battery 410 exceeding the current output current value of the battery 410.

In operation 610 of FIG. 6, the processor 420 may compare a value of the current charged through the direct charging circuit 414 and a maximum output current of a charger (TA).

Based on the value of the current charged through the direct charging circuit 414 not being lower than the maximum output current value of the charger (operation 610-No), the processor 420 may continue charging by using the direct charging circuit in operation 612.

According to an embodiment, the processor 420 may, based on the maximum output current value of the battery 410 exceeding the current output current value of the battery 410, determine a value obtained by subtracting the current output current value of the battery 410 from the maximum output current value of the battery 410 as the current value which can be additionally supplied, and determine the value of the current to be additionally supplied through the first charger 412 based on the current value which can be additionally supplied.

The processor 420 may proceed with charging by additionally using the first charger 412 in operation 614, based on the value of the current charged through the direct charging circuit 414 being lower than the maximum output current of the charger (operation 610-Yes). The processor 420 may perform charging using the first charger 412 and the direct charging circuit 414 at the same time.

According to an embodiment, the processor 420 may determine a value obtained by subtracting the current output current value of the second charger 414 from the maximum output current value of the external device as a current value which can be additionally supplied, and determine the value of the current to be additionally supplied through the first charger 412, based on the current value which can be additionally supplied.

According to an embodiment, the processor 420 may preconfigure an upper limit of the current value to be additionally supplied through the first charger 412, and control the current value additionally supplied through the first charger 412 to not exceed the configured value.

According to an embodiment, the processor 420 may identify whether the external device is able to adjust an output voltage and/or an output current based on that the external device being connected, supply a charging current to the external device by using the second charger 414 based on a state in which the output voltage and/or the output current of the external device is fixed, and supply the charging current to the battery 410 by additionally using the first charger 412 based on the charging current of the electronic device using the second charger 414 being lower than the maximum output current value of the external device.

According to an embodiment, the processor 420 may determine a charging current of the battery 410 using the second charger 414 based on the voltage of the battery 410 and the resistance value of the charging circuit, determine a current value which can be additionally supplied based on the charging current value of the battery 410 using the second charger 414 and the maximum output current value of the external device, and determine a current value to be additionally supplied through the first charger 412 based on the current value which can be additionally supplied.

According to an embodiment, based on the charging power of the external device exceeding the second level, the processor 420 may perform control to supply a charging voltage and current to the battery 410 by using the second charger 414 or to use the first charger 412 and the second charger 414 at the same time. The second level may be a situation where super-fast charging is performed with, for example, 25W. The first charger 412 may refer to an IF PMIC, and the second charger 414 may refer to a direct charger. The external device may refer to, for example, a charger that cannot support PPS.

Embodiments of the disclosure in the specifications and drawings are specific examples presented only to easily describe the technical content according to the embodiments of the disclosure and help understanding of the embodiments of the disclosure, and do not limit the scope of the embodiments of the disclosure. Therefore, the scope of an embodiment of the disclosure should be interpreted as including all changes or modified forms that may be derived from the technical idea of an embodiment of the disclosure in addition to the embodiments described herein.

## Claims

1. An electronic device (400) comprising:

   a battery (410);
   a first charger (412) comprising one of a buck converter, a boost converter, or an LDO regulator;
   a second charger (414) comprising a power converter configured to increase an input current supplied from an external device by a predetermined factor and output the increased current, and decrease an input voltage supplied from the external device by the predetermined factor and output the decreased voltage; and
   a processor (420),
   wherein the processor is configured to:

      based on the external device being connected identify whether the external device is able to adjust the output voltage and/or the output current;
      based on the external device being in a state where configurations of the output voltage and/or the output current are fixed supply a charging current by using the second charger; and

based on the charging current of the electronic device, using the second charger, becomeing lower than a maximum outputtable current value of the external device, supplying a charging current to the battery by additionally using the first charger.

2. The electronic device of claim 1, wherein the processor is configured to:

based on a voltage of the battery and a resistance value of a charging circuit, determine a charging current of the battery, using the second charger;
based on the charging current of the battery, using the second charger, and a maximum output current value of the external device, determine an additionally suppliable current value; and
based on the additionally suppliable current value, determine a current value to be additionally supplied through the first charger.

3. The electronic device of claim 2, wherein the processor is configured to:

determine, as the additionally suppliable current value, a value obtained by subtracting a current output current value of the second charger from the maximum output current value of the external device; and
based on the additionally suppliable current value, determine the current value to be additionally supplied through the first charger.

4. The electronic device of claim 2, wherein the processor is configured to:

preconfigure an upper limit of the current value to be additionally supplied through the first charger; and
control the current value additionally supplied through the first charger to not exceed the preconfigured value.

5. The electronic device of claim 1, wherein the processor is configured to receive, from the external device, a list of power data objects, PDOs, including information on voltages and currents suppliable to the battery.

6. The electronic device of claim 5, wherein the processor is configured to select a PDO from the list to determine a voltage and a current to be supplied to the battery.

7. The electronic device of claim 6, wherein the processor is configured to:

based on the voltage and the current to be supplied to the battery being determined supply the voltage and the current by preferentially using the second charger;
based on the voltage of the battery determine a current output current value of the battery; and
based on the maximum output current value of the battery exceeding the current output current value of the battery determine to additionally supply a current through the first charger.

8. The electronic device of claim 7, wherein the processor is configured to:

based on the maximum output current value of the battery exceeding the current output current value of the battery, determine, as the additionally suppliable current value, a value obtained by subtracting the current output current value of the battery from the maximum output current value of the battery; and
based on the additionally suppliable current value determine the current value to be additionally supplied through the first charger.

9. The electronic device of claim 1, wherein the processor is configured to, based on that charging power of the external device exceeds a second level, perform control to supply a charging voltage and current to the battery by using the second charger or simultaneously use both the first charger and the second charger.

10. A method of operating an electronic device, the method comprising:

based on the external device being connected identifying whether an external device is able to adjust an output voltage and/or an output current;
based on the external devic being in a state where configurations of the output voltage and/or the output current are fixed supplying a charging current by using a second charger (414); and
based on the charging current of the electronic device, using the second charger (414), becoming lower than a maximum outputtable current value of the external device, supplying a charging current to a battery by additionally using a first charger (412),

wherein the first charger comprises a DC-DC converter, and

wherein the second charger comprises a power converter configured to increase an input current supplied from the external device by a predetermined factor and output the increased current, and decrease an input voltage supplied from the external device by the predetermined factor and output the decreased voltage.

11. The method of claim 10, further comprising:

based on a voltage of the battery and a resistance value of a charging circuit, determining a charging current of the battery, using the second charger;

based on the charging current of the battery, using the second charger, and a maximum output current value of the external device, determining an additionally suppliable current value; and

based on the additionally suppliable current value determining a current value to be additionally supplied through the first charger.

12. The method of claim 11, further comprising:

determining a value obtained by subtracting a current output current value of the second charger from the maximum output current value of the external device as the additionally suppliable current value; and

determining the current value to be additionally supplied through the first charger based on the additionally suppliable current value.

13. The method of claim 11, further comprising:

preconfiguring an upper limit of the current value to be additionally supplied through the first charger; and

controlling the current value additionally supplied through the first charger to not exceed the preconfigured value.

14. The method of claim 10, further comprising receiving, from the external device a list of power data objects, PDOs, including information on voltages and currents suppliable to the battery.

15. The method of claim 14, further comprising selecting a PDO from the list to determine a voltage and a current to be supplied to the battery.

FIG. 1

FIG. 2

FIG. 3A

VBUS

Data

VSYS

310

320

PD

FG

QBAI

CI/CC/CV

Battery V, I

EP 4 718 671 A1

EP 4 718 671 A1

# FIG. 3B

CURRENT (mA)

302

6000

5000

USE CHARGER THAT SUPPORTS PPS
(USE ALLOWABLE MAXIMUM BATTERY CURRENT)

4000

USE CHARGER THAT DOES
NOT SUPPORT PPS

3000

2000

1000

304

0

0:00:00    0:20:00    0:40:00    1:00:00    1:20:00    1:40:00

TIME (MINUTE)

330

FIG. 4

FIG. 5

500

START

IDENTIFY WHETHER EXTERNAL ELECTRONIC DEVICE IS ABLE TO ADJUST
OUTPUT VOLTAGE AND/OR OUTPUT CURRENT, BASED ON THAT EXTERNAL
ELECTRONIC DEVICE IS CONNECTED — 510

PERFORM CHARGING USING SECOND CHARGER, BASED ON THAT
CONFIGURATIONS OF OUTPUT VOLTAGE AND/OR OUTPUT CURRENT ARE FIXED — 520

PERFORM CHARGING BY ADDITIONALLY USING FIRST CHARGER, BASED ON
THAT CHARGING CURRENT USING SECOND CHARGER BECOMES LOWER
THAN PREDETERMINED CONFIGURATION VALUE — 530

END

FIG. 6

```
                    ┌──────────────┐
                    │    START     │
                    └──────┬───────┘
                           │
                           ▼                        602
          ┌────────────────────────────────┐
          │    IDENTIFY AND SELECT PDO LIST │
          └────────────────┬───────────────┘
                           │
                           ▼                        604
          ┌────────────────────────────────┐
          │  START CHARGING THROUGH DIRECT  │
          │  CHARGING CIRCUIT ACCORDING TO PDO │
          └────────────────┬───────────────┘
                           │
                           ▼         610
                    ╱─────────────╲
                   ╱      IS        ╲              614
                  ╱ CHARGING CURRENT ╲     ┌──────────────────────┐
                 ╱  OF DIRECT CHARGING ╲YES│ SIMULTANEOUSLY PERFORM│
                 ╲ CIRCUIT LOWER THAN  ╱──→│ CHARGING BY ADDITIONALLY│
                  ╲ MAXIMUM OUTPUT    ╱     │ USING FIRST CHARGER   │
                   ╲ CURRENT OF TA?  ╱      └──────────┬───────────┘
                    ╲───────────────╱                  │
                           │No          612            ▼
                           ▼                      ┌──────────┐
          ┌────────────────────────────────┐      │   END    │
          │  PERFORM CHARGING THROUGH       │      └──────────┘
          │  DIRECT CHARGING CIRCUIT        │
          └────────────────────────────────┘
```

## INTERNATIONAL SEARCH REPORT

| International application No. |
| --- |
| **PCT/KR2024/008280** |

| A. | CLASSIFICATION OF SUBJECT MATTER |
| --- | --- |

**H02J 7/04**(2006.01)i; **H02J 7/00**(2006.01)i; **G01R 31/382**(2019.01)i

According to International Patent Classification (IPC) or to both national classification and IPC

| B. | FIELDS SEARCHED |
| --- | --- |

Minimum documentation searched (classification system followed by classification symbols)

H02J 7/04(2006.01); G01R 19/165(2006.01); G01R 31/382(2019.01); G05F 5/00(2006.01); H02J 7/00(2006.01); H02J 7/10(2006.01); H02J 7/34(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 충전(charging), PPS(programmable power supply), 전압(voltage), 전류 (current), 충전기(charger)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2023-0046907 A (SAMSUNG ELECTRONICS CO., LTD.) 06 April 2023 (2023-04-06) See paragraphs [0052]-[0083], claims 1-10, and figures 2-3. | 1-3,5-12,14,15 |
| Y | | 4,13 |
| Y | KR 10-2008-0019166 A (FUJITSU LIMITED) 03 March 2008 (2008-03-03) See paragraphs [0040]-[0067], claims 1-5, and figures 4-5. | 4,13 |
| A | US 2012-0041613 A1 (NAREL, Radoslaw et al.) 16 February 2012 (2012-02-16) See paragraphs [0031]-[0048], and figure 4. | 1-15 |
| A | KR 10-1720875 B1 (LG UPLUS CORP.) 29 March 2017 (2017-03-29) See paragraphs [0043]-[0086], and figures 2-7. | 1-15 |
| A | KR 10-2022-0124883 A (SAMSUNG ELECTRONICS CO., LTD.) 14 September 2022 (2022-09-14) See paragraphs [0071]-[0081], and figure 3. | 1-15 |

☐ Further documents are listed in the continuation of Box C. ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **19 September 2024** | **19 September 2024** |

| Name and mailing address of the ISA/KR | Authorized officer |
| --- | --- |
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/008280**

| Patent document cited in search report | | | Publication date (day/month/year) | Patent family member(s) | | | Publication date (day/month/year) |
|---|---|---|---|---|---|---|---|
| KR | 10-2023-0046907 | A | 06 April 2023 | CN | 118056339 | A | 17 May 2024 |
| | | | | EP | 4391281 | A1 | 26 June 2024 |
| | | | | WO | 2023-054868 | A1 | 06 April 2023 |
| KR | 10-2008-0019166 | A | 03 March 2008 | CN | 101145731 | A | 19 March 2008 |
| | | | | CN | 101145731 | B | 06 July 2011 |
| | | | | JP | 2008-054368 | A | 06 March 2008 |
| | | | | JP | 4967526 | B2 | 04 July 2012 |
| | | | | TW | 200826337 | A | 16 June 2008 |
| | | | | TW | I357170 | B | 21 January 2012 |
| | | | | US | 2008-0052550 | A1 | 28 February 2008 |
| | | | | US | 7944190 | B2 | 17 May 2011 |
| US | 2012-0041613 | A1 | 16 February 2012 | AU | 2013-241148 | A1 | 09 May 2013 |
| | | | | CN | 103066638 | A | 24 April 2013 |
| | | | | CN | 103066638 | B | 21 December 2016 |
| | | | | EP | 2587615 | A2 | 01 May 2013 |
| | | | | EP | 2587615 | A3 | 08 January 2014 |
| | | | | EP | 2587615 | B1 | 27 November 2019 |
| | | | | EP | 3667859 | A1 | 17 June 2020 |
| | | | | JP | 2013-090570 | A | 13 May 2013 |
| | | | | JP | 6161888 | B2 | 12 July 2017 |
| | | | | KR | 10-1991963 | B1 | 21 June 2019 |
| | | | | KR | 10-2013-0044180 | A | 02 May 2013 |
| | | | | US | 8332078 | B2 | 11 December 2012 |
| KR | 10-1720875 | B1 | 29 March 2017 | None | | | |
| KR | 10-2022-0124883 | A | 14 September 2022 | WO | 2022-186576 | A1 | 09 September 2022 |

Form PCT/ISA/210 (patent family annex) (July 2022)